# EUROPÄISCHE PATENTSCHRIFT

(11) **EP 2 193 581 B1**
(45) Veröffentlichungstag und Bekanntmachung des Hinweises auf die Patenterteilung: **09.11.2011**
(21) Anmeldenummer: 08785552.4
(22) Anmeldetag: 14.08.2008
(51) Int. Cl.: H01S 5/02, H01S 5/06, H01L 23/34, G01N 21/39, H01S 5/022, H01S 5/024, H01S 5/34, H01L 23/373

(54) **SPEKTRAL ABSTIMMBARES LASERMODUL**
SPECTRALLY TUNABLE LASER MODULE
MODULE LASER ACCORDABLE SPECTRALEMENT

(30) Priorität: 20.08.2007 DE 102007039219
(43) Veröffentlichungstag der Anmeldung: 09.06.2010
(73) Patentinhaber: Fraunhofer-Gesellschaft zur Förderung der angewandten Forschung e.V., 80686 München (DE)
(72) Erfinder: FUCHS, Frank, 79211 Denzlingen (DE); MORITZ, Rudolf, 79211 Denzlingen (DE); WILD, Christoph, 79211 Denzlingen (DE); WÖRNER, Eckhard, 79108 Freiburg (DE)
(74) Vertreter: Pfenning, Meinig & Partner GbR
(86) Internationale Anmeldenummer: PCT/EP2008/006703
(87) Internationale Veröffentlichungsnummer: WO 2009/024291

(56) Entgegenhaltungen:
- EP-A- 1 737 089
- WO-A-2005/112590
- DE-A1- 19 701 680
- DE-B3-102005 011 723
- US-A- 4 807 956
- US-A1- 2001 024 462
- FUCHS F ET AL: "Remote sensing of explosives using mid-infrared quantum cascade lasers" PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, Bd. 6739, Nr. 1, 5. Oktober 2007 (2007-10-05), Seiten 673904-1-9, XP007906350 ISSN: 0277-786X

## Beschreibung

Die vorliegende Erfindung bezieht sich auf ein spektral abstimmbares Lasermodul, auf ein Verfahren zum Betrieb eines solchen Lasermoduls und auf Verwendungen eines solchen. Spektral abstimmbare Lasermodule werden vor allem im Bereich der Analytik von Gasen, Flüssigkeiten und/oder Oberflächen eingesetzt.

Im Bereich der Analytik von Gasen, Flüssigkeiten und Oberflächen nehmen lasergestützte, spektroskopische Messverfahren einen immer breiteren Raum ein. Ein e-tabliertes Arbeitsgebiet stellt die Spurengasanalyse mittels einmodiger Halbleiterlaser dar. Hierbei wird die Veränderung der Emissionswellenlänge des Lasers unter elektrischem Pumpen ausgenutzt. Die Injektion eines Strompulses in die aktive Schicht des Halbleiterlasers führt zu einer Erwärmung und damit zu einer Verschiebung der Laserwellenlänge von der Größenordnung etwa einer Wellenzahl, d.h. im mittleren Infraroten Spektralbereich weniger als ein Promille. Bei leichten Molekülen mit geringen Linienbreiten und entsprechend schmaler Emissionscharakteristik des Lasers ist dies ausreichend und kann für die hochempfindliche chemisch spezifische Sensorik verwendet werden. Diese Methode ist Stand der Technik und wird im angelsächsischen Raum mit tunable diode laser spectroscopy (TDLAS) bezeichnet.

Schwere, komplexer aufgebaute, organische Moleküle weisen dagegen im infraroten Spektralbereich Spektren mit wesentlich breiteren charakteristischen Absorptionsbanden auf. Die Halbwertsbreiten liegen typischerweise bei 10 bis 30 Wellenzahlen, also weit über dem Abstimmbereich der oben beschriebenen klassischen Laserspektroskopie. Bisher erfordern solche großen Abstimmbereiche wesentlich aufwendigere Techniken, wie z. B. einen external cavity Laser (ECL) oder Frequenzmischverfahren wie sie z. B. in einem optischparametrischen Oszillator zur Anwendung kommen (OPO-System) .

Mit der klassischen TDLAS-Technik ist das Abscannen einer solch breiten Absorptionslinie nicht möglich und somit die Aussagekraft einer Messung bezüglich der chemischen Spezies und der Querempfindlichkeiten zu anderen Substanzen stark eingeschränkt.

Um den Abstimmbereich von Halbleiterlasern zu erweitern, könnte man erwägen, denselben bei größeren Strömen zu betreiben um eine größere Temperaturverschiebung zu erzielen. Die Erwärmung der aktiven Schicht eines Halbleiterlasers über den Injektionsstrom hat jedoch Grenzen. So kann prinzipiell über einen sehr hohen Injektionsstrom immer eine sehr starke Erwärmung erzielt werden, jedoch sind sehr hohe Ströme in einem Halbleiterlaser in der Regel mit ungeeigneten spektralen Charakteristika verbunden. Die Modencharakteristik wird in der Regel sehr komplex und das Rauschverhalten ungünstig. Außerdem können hohe Ströme im Bauelement nicht beherrschbare lokale Überhitzungen verursachen die letztlich zur Zerstörung führen. So stellen sich z. B. bei hohen Strömen im Bereich der Laserfacetten größere Temperaturen ein als im Volumen des Lasers, was zum Totalausfall führen kann US 2001/0024462 A1 zeigt ein Lasermoduel mit einem Siiziumträger, einem Heizelement und einem Temperatur-sensor.

Aufgabe der vorliegenden Erfindung ist es daher, ein Lasermodul zur Verfügung zu stellen, welches erlaubt, den Abstimmbereich eines mit dem Lasermodul betriebenen Lasers bzw. eines Lasers des Lasermoduls deutlich zu vergrößern im Vergleich zum Stand der Technik. Aufgabe ist es darüberhinaus, ein Lasermodul zur Verfügung zu stellen, mit der eine schnelle und genaue Steuerung der entsprechenden Abstimmung möglich ist, und mit welchem eine hohe Homogenität im durchzustimmenden Bereich erzielbar ist.

Die vorstehende Aufgabe wird durch ein Lasermodul nach Anspruch 1 gelöst. Weitere vorteilhafte Ausgestaltungsformen des erfindungsgemäßen Lasermoduls ergeben sich aus den abhängigen Ansprüchen 2 bis 13. Darüberhinaus stellt die vorliegende Erfindung ein entsprechendes Verfahren zum Betrieb des Lasermoduls zur Verfügung (Ansprüche 14 und 15). Auch Verwen - dingen werden beschrieben.

Nachfolgend wird die vorliegende Erfindung zunächst allgemein beschrieben. Sodann schließt sich ein konkretes Ausführungsbeispiel an. Die einzelnen erfindungsgemäßen Merkmale des konkreten Ausführungsbeispiels können hierbei im Rahmen der vorliegenden Erfindung nicht nur in einer Kombination, wie sie das speziell vorgestellte vorteilhafte Ausführungsbeispiel zeigt, auftreten, sondern auch im Rahmen der Erfindung in beliebigen anderen Kombinationsmöglichkeiten ausgebildet sein oder verwendet werden.

Grundlegende Idee der vorliegenden Erfindung ist es, das Lasermodul so zu gestalten, dass die Temperaturveränderung des Lasers (und die damit verbundene Verschiebung der Emissionswellenlänge des Lasers) entkoppelt von den Injektionsbedingungen des Lasers erfolgen kann. Mit einer solchen erfindungsgemäßen Entkopplung lässt sich im Vergleich zum Erwärmen des Lasers über den Injektionsstrom (wie bei der aus dem Stand der Technik bekannten TDLAS-Technik) eine wesentlich größere Temperaturverschiebung von mehreren 100 K ermöglichen (im nachfolgenden Beispiel wurden mehr als 200 K erzielt). Erfindungsgemäß erfolgt dies ohne eine zusätzliche thermische Last in die aktive Schicht des Lasers einzubringen. Die vorliegende Erfindung stellt somit ein Lasermodul zur Verfügung, bei dem sich die Temperatur des auf dem Lasermodul angeordneten Halbleiterlasers mithilfe des Diamantsubmounts des Lasermoduls sehr schnell variieren bzw. modulieren lässt. Ein entscheidender Aspekt ist hierbei das Einregeln eines schnellen Temperaturanstiegs in Kombination mit einem hohen Temperaturhub. Durch diese, durch die erfindungsgemäße Ausgestaltung mögliche, Temperaturmodulation ist die Möglichkeit gegeben, die Wellenlänge des Lasers in sehr kurzer Zeit abzustimmen. Das Lasermodul ist erfindungsgemäß so ausgebildet, das es möglich ist, die Temperatur des Lasers bzw. des Laserchips unabhängig vom Laserstrom bzw. entkoppelt von den Injektionsbedingungen des Lasers mit hoher Geschwindigkeit (insbesondere mit größer als 1000 K/s) und/oder mit hohem Hub (insbesondere größer als 100 K) zu modulieren. Somit wird ein wesentlich größerer Abstimmbereich erreicht, als es bei den aus dem Stand der Technik bekannten spektral abstimmbaren Lasern möglich ist. Weitere Vorteile der vorliegenden Erfindung lassen sich der Beschreibung des Ausführungsbeispiels entnehmen.

Erfindungsgemäß wird ein Lasermodul zur Verfügung gestellt, welches eine flächige Substratbasis (welche bevorzugt aus einem einzigen Material, insbesondere Diamant, ausgebildet ist) aufweist, wobei diese in der Regel als längliche flächige Substratbasis ausgebildet ist (Verhältnis von Länge zu Breite vorteilhafterweise > 5) und in einen Montagebereich und mindestens einen weiteren, an diesen Montagebereich angrenzenden Wärmeleitungsbereich unterteilt ist. Im Montagebereich wird dann auf der flächigen Substratbasis sowohl ein Heizelement, als auch ein Temperatursensorelement angeordnet.

In einer besonders vorteilhaften Ausgestaltungsform, die nachfolgend noch ausführlich beschrieben wird, werden in den Wärmeleitungsbereich mehrere die Substratbasis senkrecht zur Flächenebene vollständig durchschneidende Einschnitte bzw. Einsägungen eingebracht, so dass hierdurch in diesem Wärmeleitungsbereich ein mäanderförmiges thermisches Widerstandselement ausgebildet wird. Besonders vorteilhaft weist ein erfindungsgemäßes Lasertnodul auf zwei gegenüberliegenden Seiten eines zentralen Montagebereichs zwei angrenzende Wärmeleitungsbereiche auf, in welchen jeweils ein solches mäanderförmiges thermisches Widerstandselement ausgebildet ist. Vorteilhafterweise schließen sich dann noch an den bzw. den dem Montagebereich abgewandten Ende bzw. Enden der flächigen Substratbasis angrenzend an den bzw. die jeweiligen Wärmeleitungsbereich(e) ein bzw. zwei Kontaktflächenbereich(e) an. Ein solcher Kontaktflächenbereich, welcher vorteilhafterweise ebenfalls als Teil der flächigen Substratbasis ausgebildet ist, kann dann als Kontaktfläche zu einer externen Wärmesenke dienen. Vorteilhafterweise weist hierbei, wenn ebenso wie der Montagebereich als Teil der flächigen Substratbasis ausgebildet, ein solcher Kontaktflächenbereich dieselbe Wärmeleitfähigkeit auf, wie der Montagebereich.

Besonders vorteilhaft wird für die flächige Substratbasis ein Material gewählt, welches eine Wärmeleitfähigkeit von größer als 1.000 W/(K*m)aufweist. Insbesondere eignet sich hierfür Diamant.

Durch die besonders vorteilhafte Kombination eines solchen Materials hoher Wärmeleitfähigkeit mit der erfindungsgemäßen Unterteilung in einen Montagebereich (in dem sich sowohl das Heizelement als auch das Temperatursensorelement befindet und in dem dann auch der Laser angebondet wird) und den oder die danebenliegenden Wärmeleitungsbereich(e) sowie das vorteilhafte Ausbilden entsprechender Einschnittsbereiche bzw. thermischer Widerstandselemente in dem oder den Wärmeleitungsbereich(en) lässt sich nicht nur eine sehr große thermische Homogenität im Bereich der Auflagefläche des Lasers (Montagebereich) erzielen, sondern auch die Temperaturänderung sehr schnell steuern, somit der Laser sehr schnell über den gewünschten Spektralbereich abstimmen. Vorteilhafterweise werden hierzu insbesondere das Heizelement, das Temperatursensorelement und der Laser möglichst nahe beieinander im Montagebereich des flächigen Substrats angeordnet.

Weitere mögliche Modifizationen ergeben sich wie folgt:
- Das mäanderförmige thermische Widerstandselement weist mindestens vier oder mindestens sechs oder mindestens acht Einschnitte auf und/oder das Verhältnis v2=1/d von Einschnittslänge 1 und Einschnittsabstand d zweier benachbarter Einschnitte bei mindestens zwei Einschnitten des mäanderförmigen thermischen Widerstandselements ist größer als 1 oder größer als 1.5 oder größer als 2 oder größer als 3 oder größer als 5.
- Die Substratbasis, der Montagebereich, der Wärmeleitungsbereich, das Heizelement und/oder das Temperatursensorelement (5) ist/sind so angeordnet und/oder ausgebildet, dass die Temperatur eines im Montagebereich angeordneten Lasers unabhängig vom Laserstrom oder der Injektion eines Strompulses in die aktive Schicht des Lasers mit einer Geschwindigkeit von größer als 500 K/s oder größer als 1000 K/s und einem Hub größer als 50 K oder größer als 100K regelbar ist.
- Die Substratbasis weist zwei an den Montagebereich angrenzende Wärmeleitungsbereiche auf, wobei diese beiden Wärmeleitungsbereiche auf gegenüberliegenden Seiten an den Montagebereich angrenzen.
- Die Substratbasis besteht aus genau einem Material, wobei das Material bevorzugt Diamant, SiC, AIN, InP, Si oder Saphir ist.
- Die Substratbasis weist eine Wärmeleitfähigkeit von größer als 200 W/(m*K) oder von größer als 400 W/(m*K) oder von größer als 1000 W/(m*K) oder von größer als 2000 W/(m*K) auf.
- Das Heizelement weist eine Heizmetallisierung auf, wobei die Heizmetallisierung mäanderförmig ist und/oder wobei das Heizelement zwei elektrische Anschlusskontakte zum Anschluss einer Stromquelle aufweist.
- Das Temperatursensorelement des Lasermoduls weist eine Metallisierung (Temperatursensormetallisierung), welche im Montagebereich unmittelbar an genau eine Oberflächenseite der Substratbasis angrenzend angeordnet ist, auf, wobei dann das Temperatursensorelement bevorzugt auch zwei elektrische Anschlusskontakte aufweist.

Darüberhinaus wird die Verwendung eines erfindungsgemäßen Lasermoduls und/oder eines erfindungsgemäßen Verfahrens zum Betrieb eines Lasermoduls im Bereich spektroskopischer Messverfahren, im Bereich der Analyse von Gasen, Flüssigkeiten und/oder Oberflächen und/oder zur Spurengasanalyse angegeben.

Nachfolgend zeigen die Figuren 1 bis 7 des speziellen Ausführungsbeispiels:
- Figur 1: eine vorteilhafte Ausgestaltungsform eines erfindungsgemäßen Lasermoduls.
- Figur 2a: die Vorderflächenansicht V und die Rückflächenansicht R der Substratbasis 1 mit aufgebrachtem Temperatursensorelement (beim Lasermodul von Figur 1).
- Figur 2b: das entsprechende Modul von Figur 1 mit montiertem und gebondetem Laser sowie mit thermisch angebundenen Wärmesenken.
- Figur 3: den Temperaturverlauf des Lasermoduls aus Figur 1 bei verschiedenen Dauern von Heizpulsen.
- Figur 4: den zeitlichen Verlauf der Spannung am Heizelement bzw. Heizwiderstand, die Temperatur am Temperatursensorelement und die Laserintensität bei einem 100 ms Einzelpuls der Heizspannung.
- Figur 5: Leistungs-Stromkennlinien des zusammen mit dem Lasermodul gemäß Figur 1 verwendeten Lasers.
- Figur 6: die Emissionscharakteristik eines in Verbindung mit dem Modul aus Figur 1 verwendeten Quantenkaskadenlasers.
- Figur 7: verschiedene Materialien, wie sie für das flächige Substrat verwendet werden können.

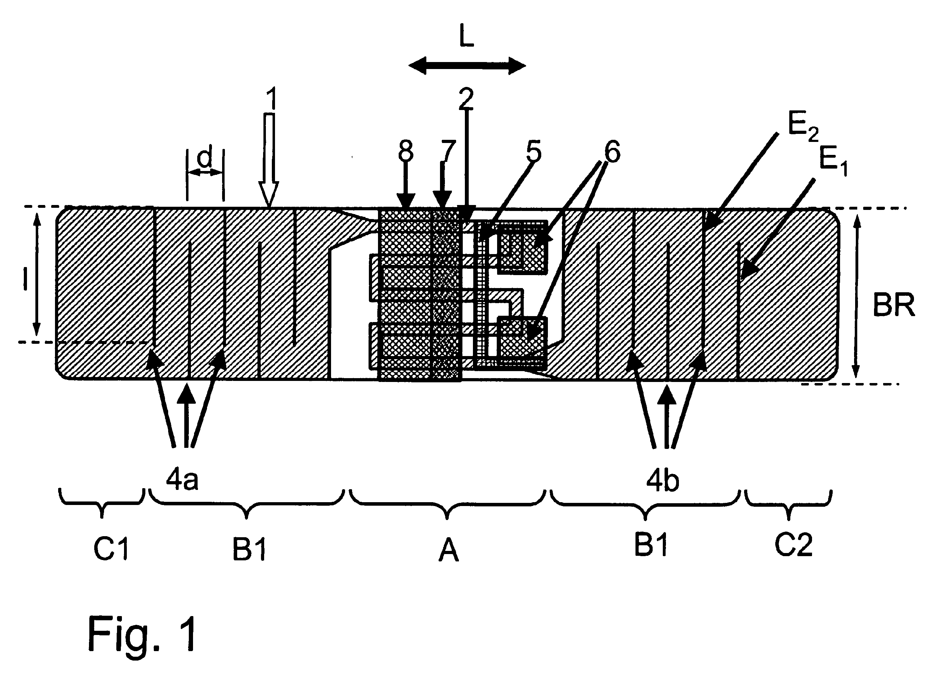

Figur 1 zeigt ein vorteilhaftes Ausführungsbeispiel eines erfindungsgemäßen Lasermoduls. Das Lasermodul weist eine flächige Substratbasis 1 aus Diamant auf, welche eine Dicke senkrecht zur hier gezeigten Flächenebene von 0.1 mm aufweist, und deren Längen-zu-Breiten-Verhältnis hier 5 beträgt (Länge in Richtung L, Breite in Richtung BR). Die flächige Substratbasis 1 ist nun entlang der Längsrichtung L in insgesamt fünf Abschnitte wie folgt unterteilt: In einen zentralen Abschnitt bzw. Bereich, die Montagefläche A, beidseits der Montagefläche bzw. des Montagebereichs A und angrenzend an diesen in jeweils einen Wärmeleitungsbereich (Bereiche B1 und B2) und in jeweils an die Wärmeleitungsbereiche B1 und B2 auf der dem Montagebereich A abgewandten Seite der Wärmeleitungsbereiche angeschlossene Kontaktflächenbereiche C1 und C2 (diese bilden somit jeweils die Endbereiche der Substratbasis aus). Der Montagebereich A und die beiden Wärmeleitungsbereiche B1 und B2 sind hierbei in Längsrichtung L etwa gleich groß; die beiden Kontaktbereiche C1, C2 weisen jeweils etwa die halbe Länge hierzu auf. Die vorstehend genannten Bereiche umfassen hierbei jeweils den gezeigten Oberflächenabschnitt auf der Oberseite der Substratbasis 1 sowie den zugehörigen, d.h. sich exakt auf der gegenüberliegenden Unterseite der Substratbasis 1 befindenden Oberflächenabschnitt. Wie nachfolgend noch näher beschrieben, sind weitere Elemente des erfindungsgemäßen Lasermoduls im Montagebereich A auf dessen Oberseite und auf dessen Unterseite bzw. auf dem entsprechenden Oberseitenabschnitt und Unterseitenabschnitt der Substratbasis angeordnet.

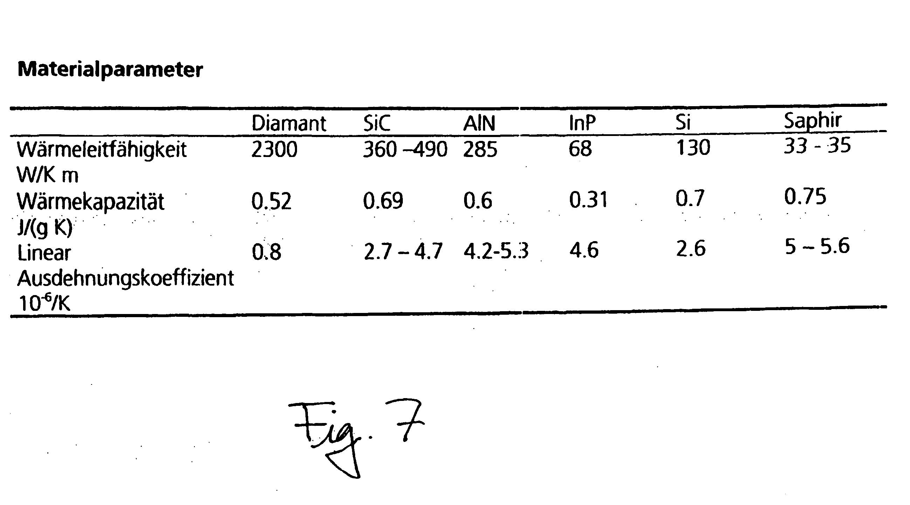

Die Abschnitte B1 und C1 einerseits sowie die Abschnitte B2 und C2 andererseits sind somit auf gegenüberliegenden Seiten des Montagebereichs A angeordnet (alle genannten Abschnitte in einer Linie). Es ist jedoch selbstverständlich auch möglich, beispielsweise die Abschnitte C1 und B1 nicht um 180° versetzt zu den Abschnitten B2 und C2 anzuordnen, sondern im 90°-Winkel (Anordnung in Form eines "L" mit dem Montagebereich A im Knickpunkt des "L"). Wie nachfolgend noch genauer beschrieben, besteht das gezeigte Lasermodul bzw. dessen Substratbasis aus einem Material hoher Wärmeleitfähigkeit (Diamant), bei dem die im Montagebereich A benachbarten Wärmeleitungsbereiche B mit reduzierter Wärmeleitfähigkeit ausgebildet werden. Im Bereich der Montagefläche A werden dann mittels vorder- und/oder rückseitiger Metallisierungen das Heizelement und das Temperatursensorelement angeordnet. Ebenso wird im Bereich A eine Laserbondmetallisierung vorgesehen, so dass der Halbleiterlaser ebenfalls im Bereich A mit der Substratbasis in Kontakt gebracht wird. In den Kontaktflächenbereichen C ist die Substratbasis so ausgestaltet, dass sie dieselbe Wärmeleitfähigkeit aufweist, wie im Montagebereich A. In diesen Bereichen C werden dann Wärmesenken (beispielsweise Kupferkörper oder ähnliches, auch flüssigkeitsbetriebene Wärmesenken oder ähnliches sind möglich, wie dem Fachmann bekannt ist) realisiert. Im Bereich A, in dem sich sowohl die Lasermontagefläche, als auch der Laser, das Heizelement und der Temperatursensor befinden, ist die flächige Substratbasis homogen und unstrukturiert ausgearbeitet, so dass sich eine hohe Wärmeleitfähigkeit ergibt. Beim im vorliegenden Beispiel verwendeten Diamantmodul mit Abmessungen 3 x 13 mm² und einer Dicke von 0.1 mm hat der nicht aufliegende Bereich B (10 x 3 mm²) eine Wärmekapazität von 5.5 10⁻³ J/K (bei 300 K). Der Wert für die Wärmesenke W sollte mindestens einen Faktor 10 darüber liegen. Hier gewählt ist etwa der Faktor 20 (ergibt 0.1 J/K für die Wärmesenke W). Mittels der Bereiche B mit reduzierter Wärmeleitfähigkeit kann nun wie folgt ein Temperaturgradient zur Wärmesenke bzw. zu den Kontaktflächenbereichen C aufgebaut werden: In den Bereichen B wird durch Einschnitte (Einsägungen) in das Material der Substratbasis 1 die Wärmeleitung gezielt reduziert. Im Bereich der Kontaktflächen C, welche den Kontakt zur Wärmesenke herstellen, hat das Modul wieder die maximale Wärmeleitfähigkeit. Für die Substratbasis 1 wird hier wie vorbeschrieben Diamant verwendet, es lassen sich jedoch auch andere Materialien wie SiC oder AIN verwenden (siehe auch Tabelle der Figur 7).

Im Montagebereich A ist nun auf der in Figur 1 gezeigten Oberseite des Moduls ein Temperatursensorelement 5 in Form einer C-förmigen Metallisierung aufgebracht. Dieses Temperatursensorelement 5 ist mit zwei elektrischen Kontakten 6 elektrisch verbunden, über die dann ein Temperatursensorkopf (beispielsweise in Form eines Widerstandsmessgerätes) angeschlossen werden kann. Ebenfalls auf der hier gezeigten Vorderseite ist im Montagebereich A eine weitere Metallisierung, die Laserbondmetallisierung 8 angeordnet. Dies dient dem Anbonden von Kontakten des verwendeten Halbleiterlasers mittels des hier ebenfalls im Bereich A angeordneten Lotdepots 7. Der verwendete Halbleiterlaser (hier nicht gezeigt) wird somit ebenfalls im Bereich A und in unmittelbarer Nähe zum Temperatursensorelement (sowie ebenfalls zum nachfolgend noch näher beschriebenen Heizelement) angeordnet.

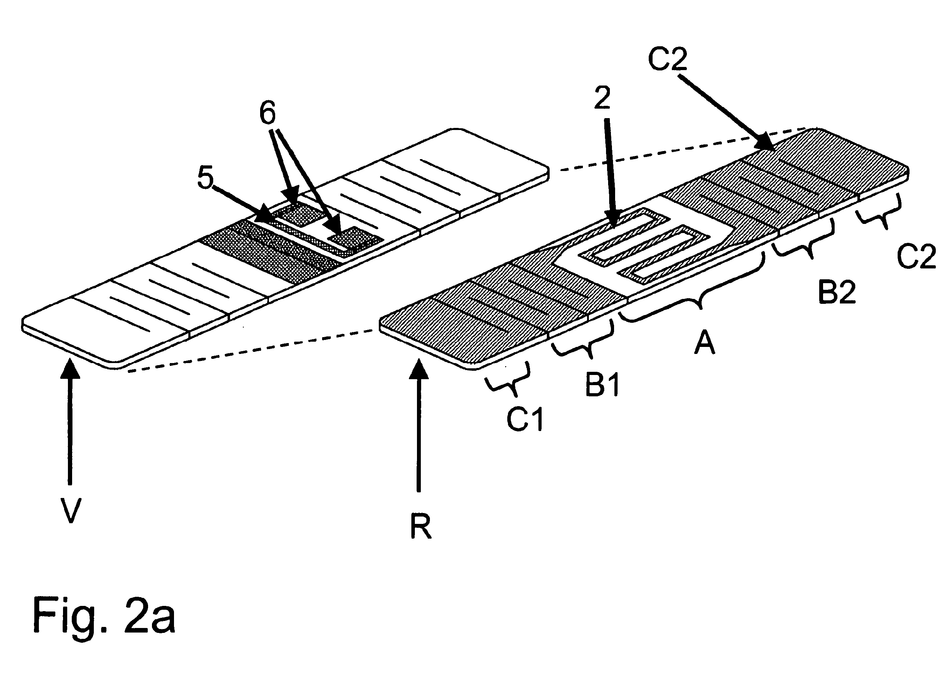

Auf der der hier gezeigten Vorderseite V gegenüberliegenden Rückseite R (vgl. Figur 2a) der Substratbasis 1 ist ebenfalls im Montagebereich A und somit in unmittelbarer Nähe zu den Elementen 5 bis 8 das Heizelement 2 in Form eines mäanderförmig verlaufenden Heizwiderstands (welcher ebenfalls als metallisierte Schicht ausgebildet ist) angeordnet. Das Heizelement 2 ist hier nicht eingefärbt, sondern lediglich anhand seiner Umrandungen gezeichnet, um darzustellen, dass es sich bezogen auf die Elemente 5 bis 8 auf der gegenüberliegenden Oberflächenseite R befindet. Auch das Heizelement 2 weist zwei (hier nicht gezeigte) elektrische Anschlusskontakte auf, mittels derer eine Stromquelle an das Heizelement 2 angeschlossen werden kann.

Jeder der beiden Wärmeleitungsbereiche B1 und B2 ist nun wie folgt ausgestaltet: In Richtung der Längsrichtung L gesehen werden alternierend (d.h. abwechselnd von beiden Seitenrändern her, hier im gezeigten Bild also von der oberen Längsschmalseite und der unteren Längsschmalseite her) Einschnitte in die Substratbasis 1 eingebracht. Diese Einschnitte (beispielsweise die Einschnitte EI und E2) werden hierbei durch die gesamte Dicke (senkrecht zur Papierebene) des Substrats eingebracht (z.B. vollständiges Durchsägen der Substratschicht). In Längsrichtung gesehen weisen hierbei benachbarte Einschnitte E1, E2 den Abstand d auf. Die Einschnittlänge, d.h. ihre Tiefe in Richtung der Breitenrichtung BR gesehen, beträgt 1. Die Länge 1 ist hierbei deutlich größer als der Abstand d, das Verhältnis beträgt hier etwa V2=1/d=4. Da die Breite BR des Substrats 1 nur unwesentlich größer als 1 ist (hier etwa 1,25*1) und da in jedem der Bereiche B1 und B2 sechs Einschnitte E vorgenommen wurden, wird in jedem der Bereiche B1 und B2 somit ein mäanderförmiges thermisches Widerstandselement ausgebildet (Widerstandselemente 4a und 4b). Wesentlich hierbei ist somit zum einen, dass das beschriebene Verhältnis V2=1/d eine Mindestgröße so aufweist und dass benachbarte Einschnitte jeweils abwechselnd von beiden Seiten (in Längsrichtung L gesehen) so eingesägt werden, dass sich für die Wärmeleitung der besagte mäanderförmige, somit im Vergleich zu der Ausdehnung der Bereiche B1 und B2 in Längsrichtung gesehen deutlich verlängerte Weg ergibt. Die vorstehend beschriebene Geometrie ist hierbei so ausgebildet, dass im gezeigten Fall das Verhältnis V1=W_{A}/W_{B} der Wärmeleitfähigkeit W_{A} des Montagebereichs A und der Wärmeleitfähigkeit W_{B} eines Wärmeleitungsbereichs B1, B2 etwa 30 ist. Der Wert dieses Verhältnisses V1 kann im Rahmen der Erfindung durch geeignetes Ausbilden und/oder Anordnen der Einschnitte des mäanderförmigen Widerstandselements und/oder der Substratbasis so festgelegt werden, dass es größer 10 ist. Vorteilhafterweise ist dieser so festgelegte Wert von V1 größer als 20, oder sogar größer als 30. Auch Werte größer als 50 sind möglich.

Entscheidend ist darüberhinaus die kompakte, integrierte Anordnung der Elemente 5 bis 8 im Montagebereich A: Entscheidende Größe hierbei sind die beiden Verhältnisse v3 und v4 wie folgt. Sei A_{H} die mittlere Ausdehnung des Heizelements in der Flächenebene (wenn das Heizelement 2 in erster Näherung quadratisch angenommen wird, entspricht dies.einer Seitenlänge des Quadrats). Sei A_{T} die entsprechende mittlere Ausdehnung des Temperatursensorelements (weist dieses beispielsweise in der Flächenebene näherungsweise die Form eines Kreises auf, so entspricht diese Ausdehnung dem Kreisdurchmesser). Bildet man nun von diesen beiden Ausdehnungswerten den Mittelwert A_{HT} und setzt diesen ins Verhältnis zum Abstand a_{HT} zwischen dem Heizelement und dem Temperatursensorelement, so sind die beiden Elemente 2, 5 so anzuordnen, dass das Verhältnis v3=a_{HT}/A_{HT} möglichst klein ist. Der Abstand ist hierbei als der Abstand der (geometrischen) Schwerpunkte der beiden Elemente 2, 5 in der Flächenebene definiert. V3 ist hier etwa 0,8. Ebenso lässt sich das Verhältnis v4=a_{HL/}A_{HL} vom Abstand a_{HL} zwischen dem Heizelement einerseits und der Laserbondmetallisierung 8 (oder dem Laser) andererseits und von der entsprechend gemittelten mittleren Ausdehnung A_{HL} des Heizelements und der Laserbondmetallisierung (oder des Lasers) definieren. Der Abstand ist hier wieder über die Schwerpunkte und in der Flächenebene definiert. Auch dieser Wert sollte so gewählt werden, dass er möglichst klein ist (er beträgt hier etwa 0,5) .

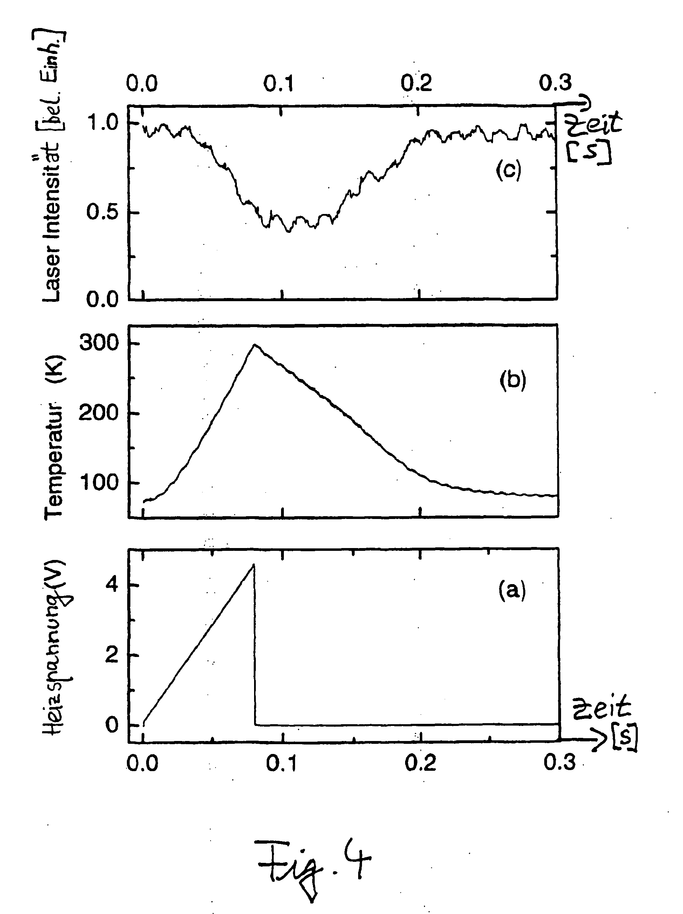

Auf der Oberseite der Substratbasis 1 ist somit in der Mitte A eine Goldmetallisierung (Laserbondmetallisierung 8) aufgebracht, die zur Montage eines Halbleiterlasers mittels Verlötung dient (siehe auch Figur 4). Auf diese Goldfläche werden die Rückkontakte des Lasers gebondet. Auf der Rückseite der Substratbasis 1 befindet sich eine weitere Metallisierung (Heizelement 2), deren Ausgestaltung (mäanderförmig) so ist, dass ein einfaches, schnelles, selektives Beheizen der mittleren Montagefläche A ermöglicht wird. Der thermische Widerstand der Montagefläche A relativ zu den seitlichen Auflageflächen (Kontaktflächen C1 und C2) wird durch die Einschnitte E in den Wärmeleitungsbereichen B1 und B2 definiert eingestellt. Wird dann die Substratbasis im Bereich C mit einer Wärmesenke W (vgl. Figur 4) kontaktiert, kann durch Beheizen der Montagefläche A des Lasers die Temperatur definiert und schnell erhöht werden. Die Metallisierung 5 bzw. das Temperatursensorelement 5 auf der Vorderseite des Moduls ermöglicht (im einfachsten Fall über eine Widerstandsmessung) eine ständige Kontrolle der Lasertemperatur.

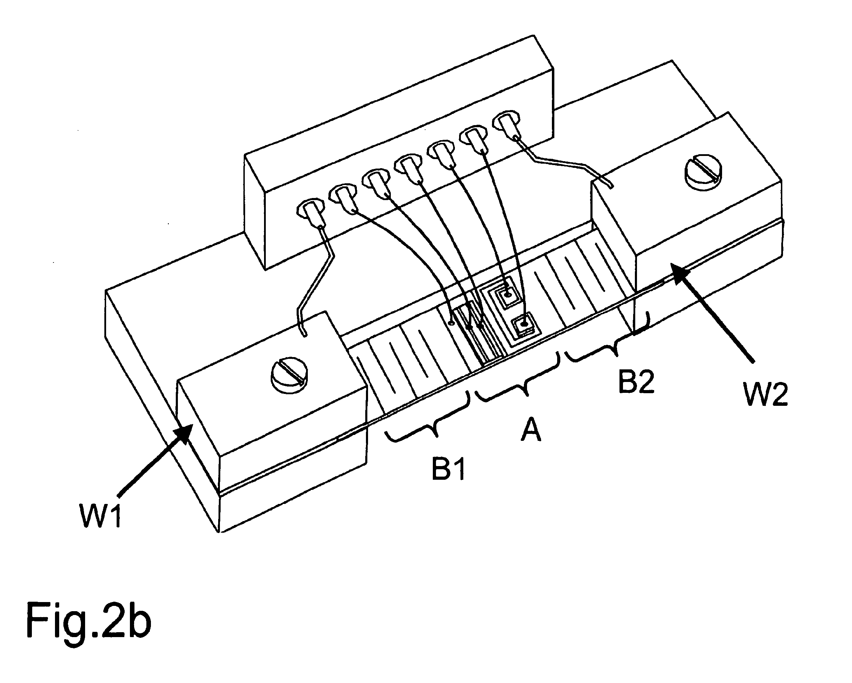

Figur 2 zeigt nun in Figur 2a eine konkrete Ausbildung eines erfindungsgemäßen Lasermoduls in Vorderseitenansicht V und Rückseitenansicht R mit der Heizmetallisierung bzw. dem Heizelement 2 auf der Rückseite R und der Temperatursensormetallisierung bzw. dem Temperatursensorelement 5 auf der Vorderseite V.

In Figur 2b ist eine Detailansicht gezeigt, hier ist lediglich noch der Montagebereich A mit den seitlich davon angeordneten Wärmeleitungsbereichen B1 und B2 sichtbar: Die Kontaktbereiche C1 und C2 werden hier durch die Wärmesenken (Kupferkörper) W1 und W2 überdeckt. Ebenfalls gezeigt ist der angebondete Laser. Die seitlichen Kupferauflageflächen der Wärmesenken W1, W2 bilden den Kontakt des Lasers zur Wärmesenke.

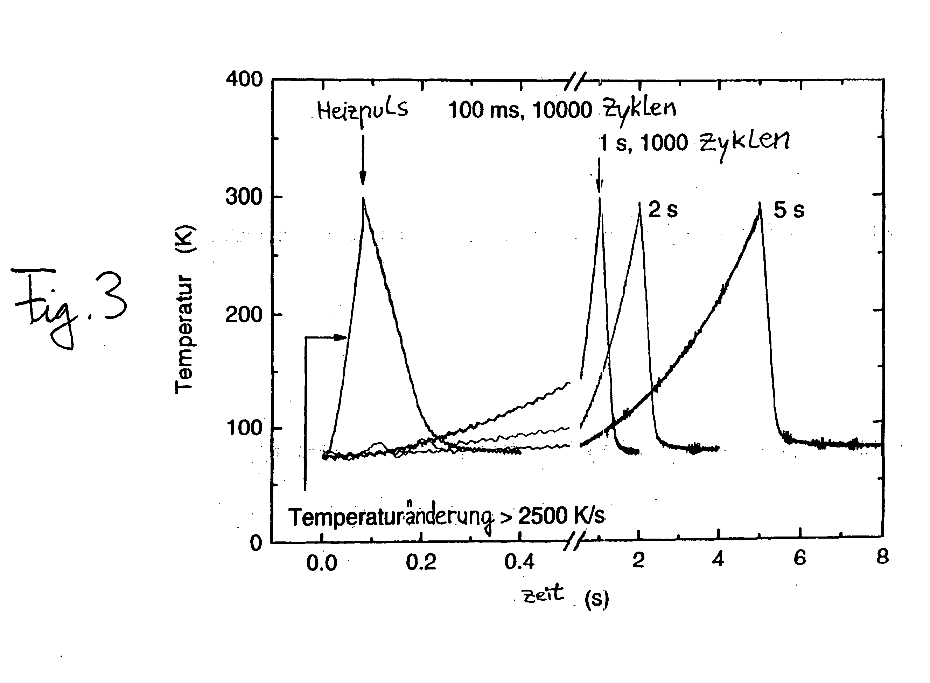

Mit Verwendung von Diamant als Werkstoff für die flächige Substratbasis 1 wird die bestmögliche Gesamtperformance des Lasermoduls erreicht. Vor allem für den schnellen Temperaturausgleich im Montagebereich A zwischen Heizelement 2, flächiger Substratbasis 1 und Temperatursensorelement 5 ist wegen der hohen Wärmeleitfähigkeit die Verwendung von Diamant vorteilhaft. Damit können sehr schnelle definierte Temperaturveränderungen erzielt werden. Es lassen sich mit dem erfindungsgemäßen Diamantmodul Raten von mehr als 2.500 K/s bei Temperaturhüben zwischen 77 K und 300 K erreichen (vgl. auch Figur 3, welche den Temperaturverlauf eines erfindungsgemäßen Lasermoduls mit Diamant-Substratbasis bei verschiedenen Dauern eines an das Heizelement 2 angelegten Heizpulses zeigt (die schnellste Rate von mehr als 2.500 K/s wurde mit einem Heizpuls der Länge 100 ms erreicht)).

In Figur 4 sind die Verläufe der Heizspannung am Heizwiderstand 5(a), der Temperatur am integrierten Sensor (im Montagebereich A) (b) und der Laserintensität (c) während eines 100 ms dauernden Heizpulses dargestellt. Das Absinken der Temperatur nach Ausschalten der Heizspannung dauert etwas länger als das Aufheizen. Die Anstiegsrate hängt hierbei vom thermischen Widerstand im Wärmeleitungsbereich B und der Heizleistung ab, die Abfallcharakteristik kann ebenfalls mit dem thermischen Widerstand eingestellt werden. Die Definition des thermischen Widerstandes ergibt sich durch die Zahl und Ausgestaltung der seitlichen Einschnitte im Diamantträger (Figur 1). Im vorliegenden Beispiel ist die Wärmeleitfähigkeit in Zone B (vgl. Fig. 1) gezielt um einen Faktor 30 reduziert worden. Somit ist nur eine sehr geringe Heizleistung nötig um die Temperatur von 77 K auf 300 K anzuheben. Die maximale Heizleistung am Ende des Heizpulses nach 80 ms beträgt nur etwa 300 mW. Die so reduzierte Wärmeleitfähigkeit limitiert die Zeit des Temperaturabfalls nach Abschalten des Heizers von 300 K zurück auf die Basistemperatur von 77 K auf ca. 150 ms (Fig. 4(b)). Durch Modifikation der Einschnitte im Bereich B kann dieses Verhalten gezielt optimiert werden. Weniger Einschnitte erhöhen die Wärmeleitfähigkeit. D.h. es wird für den gleichen Temperaturanstieg mehr Heizleistung benötigt. Dafür wird der Temperaturabfall nach Ausschalten des Heizers schneller erfolgen.

Fig. 4(c) zeigt den Intensitätsverlauf der Laseremission. Wie erwartet, reduziert sich die Laserintensität beim Verlauf von 77 K bis Raumtemperatur auf etwas unter die Hälfte. Die leichten Oszillationen der Intensität sind die Folge von Änderungen der Modenverteilung infolge der Verschiebung der Laserwellenlänge.

Zu beachten beim Betrieb des hier beschriebenen Moduls ist die unterschiedliche thermische Ausdehnung der verwendeten Materialien. Die thermische Ausdehnung von Diamant ist kleiner als die des vorliegenden III-V Halbleiters des im gezeigten Beispiel verwendeten Lasers (vgl. Fig. 7). Bei der Auslegung ist die thermisch induzierte Verspannung zwischen Diamant und dem Halbleiterlaser möglichst klein zu halten. Zudem muss die Lötverbindung zwischen Laser und Modul ausreichend stabil sein. Um die Verspannung und Wärmekapazität minimal zu halten, ist ein möglichst kleiner Laserchip zu verwenden. Ferner ist die Änderungsrate der Temperatur anzugleichen an die Zeit, die der Laserchip benötigt um eine möglichst gleichmäßige Temperaturverteilung anzunehmen. Ansonsten werden zusätzliche innere Verspannungen erzeugt, die zur Zerstörung des Laserchips führen können.

Es wurden Belastungstests mit aktivem Laserbauelement im oben beschriebenen Betriebsmodus durchgeführt: Bei Verwendung eines 2000 µm x 1000 µm großen Laserchips, auf dem sich ein 8 µm x 2000 µm großer Quantenkaskadenlaser (QC-Laser) befand, konnten 10000 Temperaturzyklen zwischen 77 K und 300 K durchgeführt werden ohne dass der Laser, der sich dabei ständig im Betrieb befand, Schaden gelitten hätte.

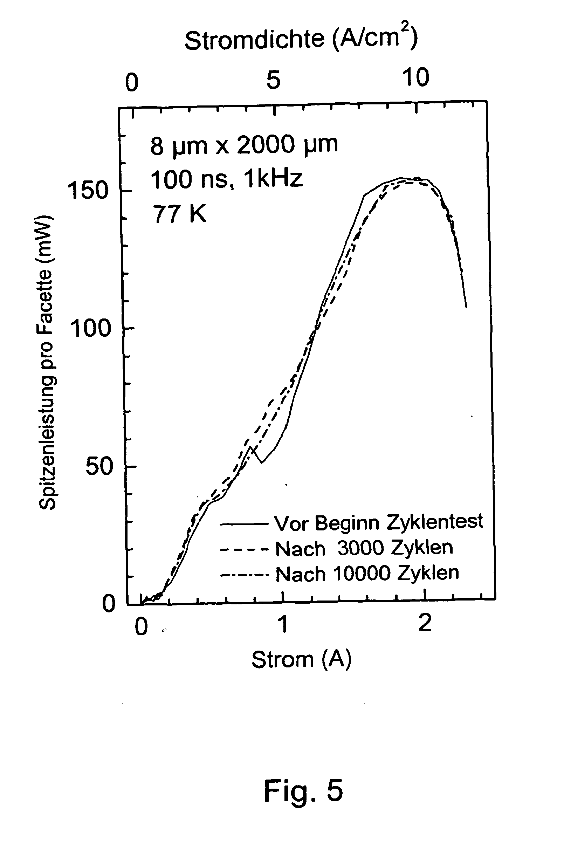

In Fig. 5 wird die optische Leistung des Lasers gegen den Injektionsstrom dargestellt (Leistungs-Strom Kennlinien des Lasers, gemessen bei 77 K).
1: Vor Beginn der Zyklentests, 2: nach 3000 Temperaturzyklen, 3: nach 7000 weiteren Zyklen. Man beobachtet leichte Änderungen der Kennlinie im mittleren Strombereich. Hier schwingen verschiedene laterale Moden an, deren Verteilung offenbar leicht variiert. Die maximale Ausgangsleistung und insbesondere der Schwellstrom haben sich im Rahmen der Messgenauigkeit auch nach insgesamt 10000 Zyklen nicht geändert.

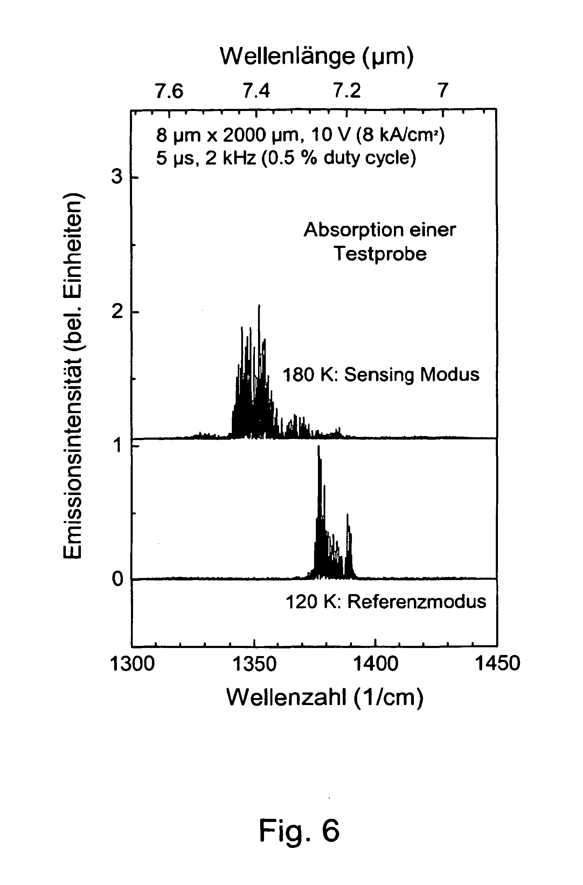

Mit der Erfindung wird ein neuartiges Konzept dargelegt, das die Erweiterung des spektralen Abstimmbereichs von Halbleiterlasern in der optischen Spektroskopie erlaubt. Ein QC-Laser, aufgebaut auf dem Diamantmodul, wird abwechselnd bei 180 K und 120 K betrieben. Die Periode des kompletten Heiz- und Kühlzyklus beträgt 1 s. Wie in der Emissionscharakteristik von Fig. 6 dargestellt, liegt die Laseremission bei 180 K genau passend zur Absorption eines komplexen Moleküls einer Testsubstanz mit breiter Absorptionsbande zentriert bei 1350 cm⁻¹. Bei 120 K verschiebt sich die Emissionscharakteristik zu 1380 cm⁻¹ (bei 120 K kann eine Referenzmessung durchgeführt werden). Mit einem geeigneten optischen Verfahren kann während der Halbperiode des Temperaturzyklus bei 180 K die Absorption gemessen werden (Sensing-Modus), wobei in der zweiten Halbperiode eine Referenzbildung ermöglicht wird (Referenz-Modus), da die Substanz im Spektralbereich um 1380 cm⁻¹ nicht absorbiert. Somit wird ein spektral differentielles Messverfahren ermöglicht, bei dem die Einzelmessung etwa im Zeitbereich zwischen 100 ms und einer Sekunde liegen kann. Der Laser wurde mit einer Stromdichte von 8 kA/cm² bei einer Pulslänge von 5 µs und einer Repetitionsrate von 2 kHz betrieben.

Figur 7 zeigt schließlich die verschiedenen Materialparameter typischer Materialien, die für die Verwendung als Substratbasis des erfindungsgemäßen Lasermoduls in Frage kommen.

## Patentansprüche

1. Lasermodul umfassend
eine flächige Substratbasis (1) mit einem Montagebereich (A) und mit mindestens einem an den Montagebereich angrenzenden Wärmeleitungsbereich (B),
ein im Montagebereich angeordnetes Heizelement (2) und einen im Montagebereich angeordneten Laser,
ein im Montagebereich angeordnetes Temperatursensorelement (5)
***dadurch gekennzeichnet, dass***
in mindestens einem der Wärmeleitungsbereiche (B) über mindestens zwei die Substratbasis senkrecht zur Flächenebene vollständig durchschneidende Einschnitte (E1, E2) ein mäanderförmiges thermisches Widerstandselement (4) ausgebildet ist.

2. Lasermodul nach dem vorhergehenden Anspruch,
***dadurch gekennzeichnet, dass***
die Einschnitte des mäanderförmigen thermischen Widerstandselements (4) und/oder die Substratbasis (1) so ausgebildet und/oder angeordnet sind, dass das Verhältnis v1=W_{A}/W_{B} der Wärmeleitfähigkeit W_{A} des Montagebereichs (A) und der Wärmeleitfähigkeit W_{B} des Wärmeleitungsbereichs (B) bei dem Lasermodul einen Wert aufweist, der größer als 10 ist.

3. Lasermodul nach einem der vorhergehenden Ansprüche,
***dadurch gekennzeichnet, dass***
die Substratbasis (1) zwei an den Montagebereich (A) angrenzende Wärmeleitungsbereiche (B1, B2) aufweist.

4. Lasermodul nach dem vorhergehenden Anspruch,
***dadurch gekennzeichnet, dass***
in beiden Wärmeleitungsbereichen (B1, B2) jeweils ein mäanderförmiges thermisches Widerstandselement (4a, 4b) ausgebildet ist.

5. Lasermodul nach einem der vorhergehenden Ansprüche,
***dadurch gekennzeichnet, dass***
das Heizelement und das Temperatursensorelement auf ein und derselben Oberflächenseite des Montagebereiches der flächigen Substratbasis angeordnet sind
oder
dass das Heizelement und das Temperatursensorelement auf den gegenüberliegenden Oberflächenseiten des Montagebereiches der flächigen Substratbasis angeordnet sind.

6. Lasermodul nach einem der vorhergehenden Ansprüche,
***dadurch gekennzeichnet, dass***
das Verhältnis v3=a_{HT}/A_{HT} vom Abstand a_{HT} zwischen Heizelement und Temperatursensorelement und von der gemittelten mittleren Ausdehnung A_{HT} des Heizelements und des Temperatursensorelements kleiner als 1.5 oder kleiner als 1 oder kleiner als 0.5 oder kleiner als 0.5 oder kleiner als 0.1 ist.

7. Lasermodul nach einem der vorhergehenden Ansprüche,
***dadurch gekennzeichnet, dass***
das Heizelement eine Metallisierung (Heizmetallisierung), welche im Montagebereich unmittelbar an genau eine Oberflächenseite der Substratbasis angrenzend angeordnet ist, aufweist.

8. Lasermodul nach einem der vorhergehenden Ansprüche
***dadurch gekennzeichnet, dass***
der im Montagebereich (A) angeordnete Laser ein einmodiger Halbleiterlaser oder ein Quantenkaskadenlaser ist.

9. Lasermodul nach dem vorhergehenden Anspruch,
***dadurch gekennzeichnet, dass***
einerseits eine Laserbondmetallisierung und/oder der Laser und andererseits das Temperatursensorelement auf gegenüberliegenden Oberflächenseiten des Montagebereiches der flächigen Substratbasis angeordnet sind, wobei bevorzugt folgendes gilt: das Verhältnis v4=a_{HL}/A_{HL} vom Abstand a_{HL}. zwischen
Heizelement einerseits und Laser und/oder Laserbondmetallisierung andererseits und von der gemittelten mittleren Ausdehnung A_{HL} des Heizelements und des Lasers und/oder der Laserbondme-tallisierung ist kleiner als 1.5 oder kleiner als 1 oder kleiner als 0.5 oder kleiner als 0.5 oder kleiner als 0.1.

10. Lasermodul nach einem der vorhergehenden Ansprüche,
***dadurch gekennzeichnet, dass***
die Substratbasis (1) mindestens einen sich auf der dem Montagebereich (A) abgewandten Seite mindestens eines der Wärmeleitungsbereiche (B) an diesen Wärmeleitungsbereich (B) anschließenden Kontaktflächenbereich (C) aufweist.

11. Lasermodul nach dem vorhergehenden Anspruch
***gekennzeichnet durch***
eine Wärmesenke (W), welche thermisch mit dem Kontaktflächenbereich (C) gekoppelt ist und/oder an den Kontaktflächenbereich (C) angrenzend angeordnet ist, wobei bevorzugt folgendes gilt:
- die Wärmesenke ist als Festkörper mit einer spezifischen Wärmekapazität von größer als 0.1 J/K ausgebildet ist, und/oder
- die Wärmekapazität des Montagebereichs (A) und die Wärmekapazität mindestens eines der Kontaktflächenbereiche (C) sind identisch.

12. Lasermodul nach einem der vorhergehenden Ansprüche,
***dadurch gekennzeichnet, dass***
die Substratbasis (1) eine Dicke senkrecht zur Flächenebene von zwischen 20 µm und 500 µm aufweist.

13. Verfahren zum Betrieb eines Lasermoduls,
***dadurch gekennzeichnet, dass***
an das Heizelement eines Lasermoduls nach einem der vorhergehenden Ansprüche mindestens ein ansteigender elektrischer Spannungspuls angelegt wird.

14. Verfahren nach dem vorhergehenden Anspruch,
***dadurch gekennzeichnet, dass***
der elektrische Spannungspuls rampenförmig ansteigt und/oder dass der elektrische Spannungspuls eine Pulsdauer von zwischen 10 ms und 500 ms oder zwischen 50 ms und 200 ms aufweist, wobei bevorzugt der elektrische Spannungspuls so ausgebildet wird, dass die Temperatur eines im Montagebereich (A) des Lasermoduls angeordneten Lasers unabhängig vom Laserstrom oder der Injektion eines Strompulses in die aktive Schicht des Lasers mit einer Geschwindigkeit von größer als 500 K/s oder größer als 1000 K/s und/oder einem Hub von größer als 50 K oder größer als 100 K geregelt wird.

## Claims

1. Laser module comprising
a flat substrate base (1) with a mounting area (A) and with at least one thermal conduction area (B) adjacent to the mounting area,
a heating element (2) located in the mounting area and a laser located in the mounting area,
a temperature sensor element (5) located in the mounting area,
***characterised in that***
a meander-shaped thermal resistance element (4) is formed in at least one of the thermal conduction areas (B) by means of at least two incisions (E1, E2) cutting completely through the substrate base perpendicular to the surface plane.

2. Laser module according to the preceding claim,
***characterised in that***
the incisions of the meander-shaped thermal resistance element (4) and/or the substrate base (1) are formed and/or are arranged so that the ratio v1=W_{A}/W_{B} of the thermal conductivity W_{A} of the mounting area (A) and the thermal conductivity W_{B} of the thermal conduction area (B) in the laser module has a value which is greater than 10.

3. Laser module according to one of the preceding claims,
***characterised in that***
the substrate base (1) has two thermal conduction areas (B1, B2) adjacent to the mounting area (A).

4. Laser module according to the preceding claim,
***characterised in that***
a meander-shaped thermal resistance element (4a, 4b) is formed in each of the two thermal conduction areas (B1,
B2).

5. Laser module according to one of the preceding claims,
***characterised in that***
the heating element and the temperature sensor element are located on one and the same surface side of the mounting area of the flat substrate base
or
**in that** the heating element and the temperature sensor element are located on the opposite surface sides of the mounting area of the flat substrate base.

6. Laser module according to one of the preceding claims,
***characterised in that***
the ratio v3=a_{HT}/A_{HT} of the distance a_{HT} between the heating element and temperature sensor element and of the determined average extent A_{HT} of the heating element and of the temperature sensor element is less than 1.5 or less than 1 or less than 0.5 or less than 0.5 or less than 0.1.

7. Laser module according to one of the preceding claims,
***characterised in that***
the heating element has a metallisation (heating metallisation) which is located in the mounting area immediately adjacent to exactly one surface side of the substrate base.

8. Laser module according to one of the preceding claims,
***characterised in that***
the laser located in the mounting area (A) is a single-mode semiconductor laser or quantum cascade laser.

9. Laser module according to the preceding claim,
***characterised in that***
on the one hand a laser bond metallisation and/or the laser and on the other hand the temperature sensor element are located on opposite surface sides of the mounting area of the flat substrate base, where preferably the following holds true: the ratio v4=a_{HL}/A_{HL}. of the distance a_{HL} between the heating element on the one hand and the laser and/or laser bond metallisation on the other hand and of the determined average extent A_{HL} of the heating element and of the laser and/or of the laser bond metallisation is less than 1.5 or less than 1 or less than 0.5 or less than 0.5 or less than 0.1.

10. Laser module according to one of the preceding claims,
***characterised in that***
the substrate base (1) has at least one contact surface area (C) which, on the side of at least one of the thermal conduction areas (B) that faces away from the mounting area (A), is adjacent to this thermal conduction area (B).

11. Laser module according to the preceding claim,
***characterised by***
a heat sink (W) which is thermally coupled with the contact surface area (C) and/or is located adjacent to the contact surface area (C), where preferably the following holds true:
- the heat sink is formed as a solid body with a specific thermal capacity of greater than 0.1 J/K, and/or
- the thermal capacity of the mounting area (A) and the thermal capacity of at least one of the contact surface areas (C) are identical.

12. Laser module according to one of the preceding claims,
***characterised in that***
the substrate base (1) has a thickness perpendicular to the surface plane of between 20 µm and 500 µm.

13. Method for the operation of a laser module,
***characterised in that***
at least one rising electrical voltage pulse is applied to the heating element of a laser module according to one of the preceding claims.

14. Method according to the preceding claim,
***characterised in that***
the electrical voltage pulse rises in a ramp and/or **in that** the electrical voltage pulse has a pulse duration of between 10 ms and 500 ms or between 50 ms and 200 ms, the electrical voltage pulse preferably being formed so that the temperature of a laser located in the mounting area (A) of the laser module is regulated independently of the laser current or the injection of a current pulse into the active layer of the laser at a rate of greater than 500 K/s or greater than 1000 K/s and/or a swing of greater than 50 K or greater than 100 K.

## Revendications

1. Module laser, comprenant :
une base substrat plane (1) avec une zone de montage (A) et avec au moins une zone de conduction thermique (B) adjacente à la zone de montage,
un élément chauffant (2) agencé dans la zone de montage et un laser agencé dans la zone de montage,
un élément capteur de température (5) agencé dans la zone de montage, **caractérisé en ce que**
un élément de résistance thermique (4) conformé en méandres est aménagé dans au moins une des zones de conduction thermique (B) sur au moins deux entailles (E1, E2) traversant complètement la base substrat perpendiculairement au plan de sa surface.

2. Module laser selon la revendication précédente,
**caractérisé en ce que**
les entailles de l'élément de résistance thermique (4) conformé en méandres et/ou la base substrat (1) sont conformées et/ou aménagées de sorte que le rapport v1= W_{A}/W_{B} de la conductivité thermique W_{A} de la zone de montage (A) et de la conductivité thermique W_{B} de la zone de conduction thermique (B) présente, dans le module laser, une valeur qui est supérieure à 10.

3. Module laser selon l'une quelconque des revendications précédentes, **caractérisé en ce que**
la base substrat (1) présente deux zones de conduction thermique (B1, B2) adjacentes à la zone de montage (A).

4. Module laser selon la revendication précédente,
**caractérisé en ce que**
un élément de résistance thermique (4a, 4b) conformé en méandres est respectivement formé dans les deux zones de conduction thermique (B1, B2).

5. Module laser selon l'une quelconque des revendications précédentes, **caractérisé en ce que**
l'élément chauffant et l'élément capteur de température sont agencés sur une seule et même face de la zone de montage de la base substrat plane, ou
**en ce que** l'élément chauffant et l'élément capteur de température sont agencés sur les faces opposées de la zone de montage de la base substrat plane.

6. Module laser selon l'une quelconque des revendications précédentes, **caractérisé en ce que**
le rapport v3 = a_{HT}/ _{AH}T de la distance a_{HT} entre l'élément chauffant et l'élément capteur de température à la dilatation moyennée moyenne A_{HT} de l'élément chauffant et de l'élément capteur de température est inférieur à 1,5 ou inférieur à 1 ou inférieur à 0,5 ou inférieur à 0,5 ou inférieur à 0,1.

7. Module laser selon l'une quelconque des revendications précédentes, **caractérisé en ce que**
l'élément chauffant comprend une métallisation (métallisation de chauffage) qui est aménagée dans la zone de montage en position attenante directement à exactement une face de la base substrat.

8. Module laser selon l'une quelconque des revendications précédentes, **caractérisé en ce que**
le laser agencé dans la zone de montage (A) est un laser à semi-conducteur monomode ou un laser à cascade quantique.

9. Module laser selon la revendication précédente,
**caractérisé en ce que,**
d'une part, une métallisation de connexion du laser et/ou le laser et, d'autre part, l'élément capteur de température sont agencés sur des faces opposées de la zone de montage de la base substrat plane, dans lequel ce qui suit est de préférence vérifié: le rapport v4 = a_{HL}/A_{HL} de la distance a_{HL} entre l'élément chauffant, d'une part, et le laser et/ou la métallisation de connexion du laser, d'autre part, à la dilatation moyenne A_{HL} de l'élément chauffant et du laser et/ou de la métallisation de connexion du laser est inférieur à 1,5 ou inférieur à 1 ou inférieur à 0,5 ou inférieur à 0,5 ou inférieur à 0,1.

10. Module laser selon l'une quelconque des revendications précédentes, **caractérisé en ce que**
la base substrat (1) présente du côté d'au moins une des zones de conduction thermique (B) opposé à la zone de montage (A), à cette zone de conduction thermique (B).

11. Module laser selon la revendication précédente,
**caractérisé par**
un puits de chaleur (W), qui est couplé thermiquement à la zone de face de contact (C) et/ou agencé en position attenante à la zone de face de contact (C), dans lequel ce qui suit est vérifié:
- le puits de chaleur se présente sous la forme d'un corps solide ayant une capacité thermique spécifique supérieure à 0,1 J/K, et/ou
- la capacité thermique de la zone de montage (A) et la capacité thermique d'au moins une des zones de face de contact (C) sont identiques.

12. Module laser selon l'une quelconque des revendications précédentes, **caractérisé en ce que**
la base substrat (1) présente une épaisseur perpendiculairement au plan de la base substrat comprise entre 20 µm et 500 µm.

13. Procédé pour faire fonctionner un module laser,
**caractérisé en ce que,**
on applique au moins une impulsion de tension électrique croissante sur l'élément chauffant d'un module laser selon l'une quelconque des revendications précédentes,

14. Procédé selon la revendication précédente,
**caractérisé en ce que**
l'impulsion de tension électrique croît en forme de rampe et/ou **en ce que** l'impulsion de tension électrique présente une durée d'impulsion comprise entre 10 ms et 500 ms ou entre 50 ms et 200 ms, dans lequel l'impulsion de tension électrique est de préférence formée de sorte que la température d'un laser agencé dans la zone de montage (A) du module laser soit réglée indépendamment du courant de laser ou de l'injection d'une impulsion de courant dans la couche active du laser à une vitesse supérieure à 500 K/s ou supérieure à 1000 K/s et/ou à une élévation supérieure à 50 K ou supérieure à 100 K.
